Europäisches Patentamt

European Patent Office

Office européen des brevets

(11) Publication number: **0 171 239**
**A1**

(12) # EUROPEAN PATENT APPLICATION

(21) Application number: **85305345.2**

(22) Date of filing: **26.07.85**

(51) Int. Cl.⁴: **H 01 T 19/00**

(30) Priority: **26.07.84 JP 156937/84**

(43) Date of publication of application: **12.02.86**
**Bulletin 86/7**

(84) Designated Contracting States: **DE FR GB IT**

(71) Applicant: **Nippon Paint Company, Ltd, 2-1-2, Oyodokita Oyodo-ku, Osaka-shi Osaka-fu (JP)**
Applicant: **SANKYO DENGYO COMPANY, LIMITED, 14-13, Hon-cho 1-Chome, Nakano-ku Tokyo (JP)**

(72) Inventor: **Ikeda, Shoji, 2-503, 67, Nishimachi, Ikaga, Hirakata-shi Osaka-fu (JP)**
Inventor: **Tsutsui, Koichi, 5-chome, 13-4, Osumigaoka Tanabe-cho, Tsuzuki-gun Kyoto-fu (JP)**
Inventor: **Saitoh, Toshiyuki, 3-7-26, Hon-cho, Ageo-shi Saitama-ken (JP)**
Inventor: **Inagaki, Tsuguya, Tokochi-Danchi 5-542 2469, Nagatsuda-cho Midori-ku, Yokohama-shi Kanagawa-ken (JP)**

(74) Representative: **Perry, Robert Edward et al, GILL JENNINGS & EVERY 53-64 Chancery Lane, London WC2A 1HN (GB)**

(54) **Apparatus and method for surface treatment.**

(57) Apparatus suitable for use in the surface treatment of an article (6), in which the apparatus comprises two opposing electrodes (1, 2) and means for applying a high-voltage difference and thereby activating the surface of an article (6) disposed between the electrodes (1, 2), characterised in that one of the electrodes (1) includes a flexible contact member (3) which can follow the contours of the article (6).

The apparatus can be used to activate the surface of the article (6), e.g. if the article (6) and the contact member (3) are moved relative to each other. Activation is preferably in a plasma.

## APPARATUS AND METHOD FOR SURFACE TREATMENT

The present invention relates to an apparatus and a method for surface treatment. In particular, the invention relates to surface treatment in the plasma state, for uniformly and rapidly obtaining physical and chemical modifications of the surfaces of articles such as plastics, fibrous products and moulded items of, say, paper or wood, under various gases and at various temperature and pressure conditions.

It is known to modify the physical properties of articles as described above, e.g. in order to improve surface adhesion, coating, bonding, wettability or durability, by chemical methods, e.g. by using acid, alkali, ultra-violet irradiation or flame treatment. These methods have both merits and demerits. For example, chemical treatment has the drawback of complexity, since a wet process is required. Further, ultra-violet irradiation is not suitable for treating articles having irregular contours. Moreover, flame treatment is limited in applicability owing to the high temperatures to which the articles must be exposed.

Surface treatment methods using plasma are potentially both convenient and effective. Sub-atmospheric pressure plasma treatment is widely used, but the need for reduced pressure is inconvenient when the article is large in size, and the technique requires careful sealing of the surface treatment apparatus.

According to a first aspect of the present invention, for use in the surface treatment of an article, apparatus comprises two opposing electrodes and means for applying a high voltage difference and thereby activating the surface of an article disposed between the electrodes, in which one of the electrodes has a flexible contact member which can follow the contours of such an article.

According to a second aspect of the present invention, a method for activating the surface of an article comprises disposing the article between two opposing electrodes and applying a high voltage difference between the electrodes, in which one of the electrodes has a contact member which is in contact with the article and which is flexible to the extent that it can follow the contours of the article.

Of the two opposing electrodes, either the one including the contact member or the other may be termed the "excitation" electrode. The electrode which does not include the contact member may be formed of an electrically-conductive material such as metal or carbon, and may have any suitable configuration such as that of a plate or cylinder, depending on the contour of the article to be treated; preferably, it carries a dielectric layer on its surface, in order to prevent local concentration of the electric field, and to ensure uniform treatment of an article. The dielectric layer may be made of, for example, glass, ceramics, enamel, asbestos, marble, slate, mica or plastics, e.g. epoxy resin, polyimide nylon or fluorine plastics such as 2-vinylidene fluoride 4-ethylene fluoride 6-propylene fluoride copolymer or 4-ethylene fluoride perfluoro-alkoxy copolymer. The thickness of the dielectric layer can be selected according to the overall requirements for the apparatus, but is preferably 0.1 to 10 mm.

The means for applying the necessary voltage can be any conventional supply circuit. It is desirable that the supply circuit should be capable of controlling arbitrarily, in accordance with a load, the discharge current for producing plasma, and should be capable of frequency adjustment and high-voltage power output, to respective optimum levels. For example, a stabilising power source may be used, together with a detector for detecting electric current and voltage, and a control device for controlling the high-voltage power source. Signals indicative of the electric current and the voltage are fed back to the control device from the detector, thereby allowing output electric current and output voltage to be optimised in accordance with loads applied between the electrodes. The use of a stabilising power source makes it possible to treat articles having complicated contours uniformly, in the plasma state.

The voltage is usually from 10 to 50 kV and preferably from 10 to 30 kV. The frequency for the power source is preferably from 1 to 100 kHz.

The flexible contact member may be in the form of fibres, a sheet, cloth or leaf. It may consist of a known good conductor such as a metal or carbon. Specific examples of suitable contact members are electrically-conductive fibres, aluminium foil, steel wire, stainless steel wire, stainless steel fibre, stainless steel cloth, stainless steel web, stainless steel felt, brass wires, copper wires, copper foil and carbon fibre cloth.

The contact member may be formed of a composite of a conductor and an insulator. For example, it may comprise rubber having a high content of carbon or metal powder, electrically-conductive plastics, metal-plated fibres or composite fibres comprising core and sheath portions, the sheath being a synthetic fibre and the core including an electrically-conductive layer having a large content of metal powder or carbon.

The contours of the contact member, especially its radius of curvature at its distal end, are important in their effect on the type and stability of the electrical discharge. As the radius of curvature at the distal end decreases, more stable plasma can be obtained at low voltages, but damage and electrical disconnection of the contact member can take place more readily. The preferred radius of curvature at the distal end of the contact member is 0.005 to 0.5 mm.

One specific example of a contact member is a plurality of composite electrically-conductive fibres 50 µm in diameter and 100 mm long. The fibres are bonded to an electrically-conductive base member by an electrically-conductive bonding agent, and are pressed into a brush-like configuration. A fibrous contact member can also be obtained by similar arrangement of plurality of tow-type stainless steel fibres, e.g. those marketed under the trade name Naslon by Nihon Scisen Co., Ltd., Japan and now widely used in the industry, or twisted yarns.

Alternatively, a brush-like contact member having relatively hard bristles can be made by using elastic phosphor bronze wires cut to a length of 50 mm and arranged in a sheet-like shape 1 mm thick. The diameter of such wires is selected in accordance with their electrical discharge properties and durability, and is preferably 0.008 to 0.5 mm. A brush-like contact member can be obtained by pressing end portions of the wires, using a metal plate.

An alternative specific example of a contact member for use in the invention comprises a plurality of essentially rectangular sheets, e.g. aluminium foils 0.01 to 0.2 mm thick and 5 mm wide, secured to a metal plate. A cloth-like contact member can be obtained by cutting a carbon fibre fabric or a stainless steel cloth, web or felt, e.g. to a thickness of 0.5 mm, and securing it to a metal plate.

In use, the flexible contact member is usually brought into wiping contact of the surface of the article to be treated. It is therefore essential that the flexibility should be sufficient to avoid damage. In order to improve the effect of the apparatus and method of the invention, it may be appropriate to use a plurality of electrodes including flexible contact members.

In general, the shape of the contact member will be chosen having regard to the contours of the article to be treated. Further, the time of treatment will be chosen according to the nature of the article to be treated, as well as the applied voltage and frequency.

In order to obtain wiping contact of the flexible contact member with the article to be treated, these two elements are displaced relative to one another. For example, the electrodes may be stationary and the article displaced. Alternatively, the electrode including the flexible contact member may be moved while the article to be treated is secured to the other electrode. The relative motion may be linear, circular and/or rotary. The motion can be constant or varied; variation may be continuous or intermittent, depending on the nature of the article, but in any case can be suitable for the treatment of articles having complicated contours. If the "wiping" speed of the contact member relative to the article is 50 mm/s or less, however, the effect of treatment is often reduced.

It is usually convenient and most desirable for the article to be treated in atmospheric air under ambient conditions. Depending on such factors as the adhesion between the coating film and the surface being treated, the coating itself, the bond, wettability and durability, it may also be appropriate that one or more of such various gases as nitrogen, oxygen (and especially nitrogen and/or oxygen), carbon dioxide, carbon monoxide, ammonia, nitrogen oxide, halocarbons, vinyl compounds, argon or helium are introduced into a chamber within which the apparatus is contained. It may also be suitable that a containing tank is hermetically sealed, so that the article can be treated at sub-atmospheric or super-atmospheric pressure.

The article to be treated may be of an insulating material. It may be of inorganic material such as glass, mica or ceramics, an organic material such as paper, organic fibres, cloth, wood or plastics such as a polyolefin, acrylic or nylon material, or a composite comprising both inorganic and organic materials of this type.

The invention will now be described by way of example only with reference to the accompanying drawings, in which:

Figure 1 is a schematic view of one embodiment of apparatus of the present invention;

Figure 2 is a schematic view of apparatus of the invention in use;

Figure 3 is a perspective view of an article which can be treated in accordance with the invention; and

Figures 4a to 4d are schematic views of embodiments of flexible contact members which can be used in the invention.

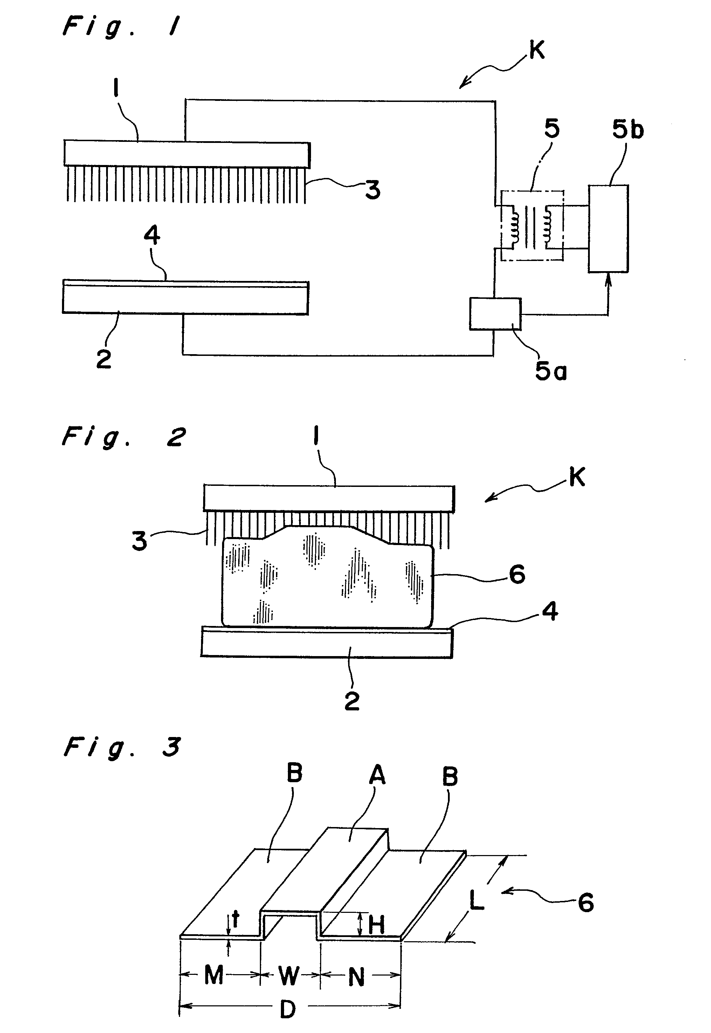

Figure 1 shows apparatus K including an upper electrode 1 and, opposing the upper electrode 1, a lower electrode 2. Here and in general, either of the two electrodes can act as an "excitation" electrode.

The upper electrode 1 includes a flexible contact member 3 in the form of a plurality of electrically-conductive fibres. These fibres can follow the contours of an article disposed between the electrodes.

The lower electrode 2 is formed of an electrically-conductive material such as metal or carbon. A dielectric layer 4 is provided on the surface of the lower electrode 2.

Figure 1 shows also the electrical circuit by which high voltage is applied between the electrodes 1 and 2, and which comprises a stabilising power source 5, a detector 5a for detecting electric current and voltage, between the stabilising power source and the lower electrode 2, and a control device 5b for controlling the high-voltage power source 5. Signals indicative of the electric current and the voltage are fed back to the control device 5b from the detector 5a, and it is thus possible arbitrarily to set the output electric current and the output voltage at respective optimum values in accordance with the loads applied between the electrodes 1 and 2.

In common with Fig. 1, Fig. 2 shows the electrodes 1 and 2, the flexible contact member 3 and the dielectric layer 4. It shows also an article 6 which itself is illustrated in greater detail in Fig. 3. With reference to Fig. 2, the article 6 is treated by applying a voltage and moving the article 6 relative to the contact member 3.

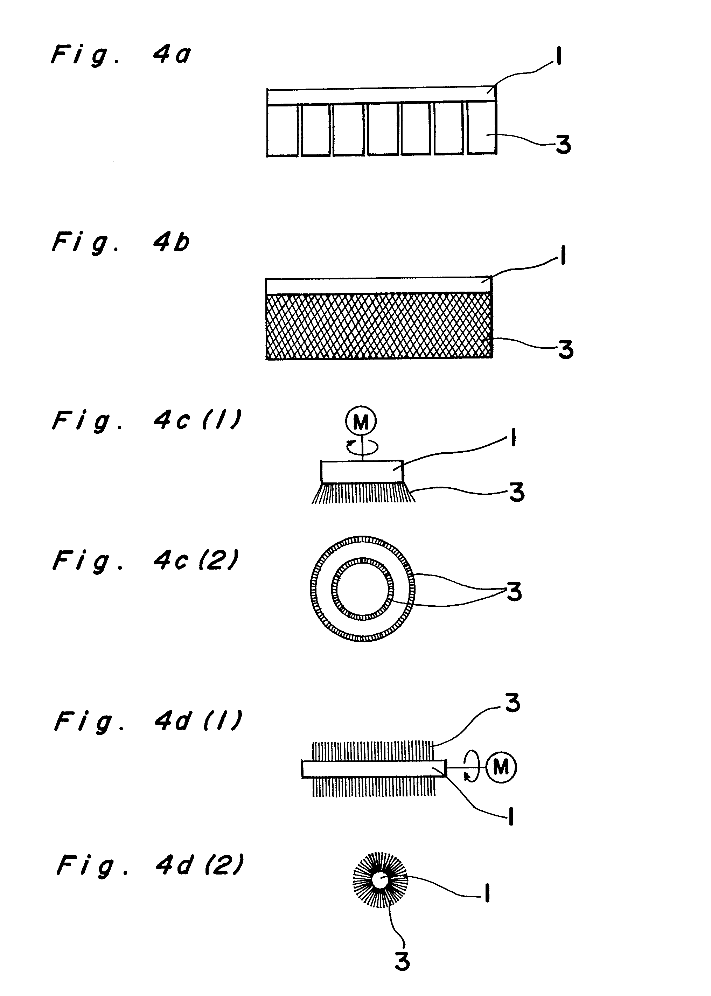

Fig. 4a shows a contact member 3 in the form of a plurality of rectangular sheet-like members. Fig. 4b shows a cloth-like contact member 3. Figs. 4c(1) and 4c(2) are, respectively, a front elevational view and a bottom plan view of a fibrous (brush-like) contact member 3 composed of two coaxial circular bristle portions intended to be rotated about the common axis. Figs. 4d(1) and 4d(2) are, respectively, a front elevational view and a side elevational view of a fibrous (brush-like) contact member 3 in which bristles extends radially from, and axially along, a rod-like electrode 1; it is intended that, in use, the electrode 1 and thus the contact member 3 should be rotated about the axis of the electrode 1.

The following Examples illustrate the invention, with reference to the accompanying drawings.

Example 1

A rectangular aluminium foil 100 mm wide was suspended from an excitation electrode 1. An aluminium plate 1 mm thick was employed as the opposite electrode 2, and to this was secured a sheet 6 of polypropylene, 45 mm wide. The electrode 2 and the sheet 6 were displaced relative to the excitation electrode at 10, 5, 2.5 or 1.25 mm/s, such that the aluminium contact member 3 came into wiping contact with the surface of the sheet. At the same time, a voltage of 20 kV at a frequency of 5 kHz was applied between the electrodes, to effect electrical discharge such that plasma was produced.

After it had been treated in the plasma state by the surface treating apparatus K, the polypropylene sheet was subjected to spray-coating using a two-part liquid system polyurethane. Its bonding strength was then examined by the 180° peel test. The result was 1800, 1890, 2000 or 2040 g/cm, respectively, depending on the respective displacement speed. By contrast, a sheet which has not been treated by the surface treating apparatus K has a peeling strength no more than 200 g/cm.

Example 2

A polypropylene sheet was treated in the plasma state by the surface treating apparatus K, under the same conditions as in Example 1, except that a cloth-like contact member 3, formed from a carbon fibre fabric 50 mm long, was employed.

The peel strengths for the four respective displacement speeds were 1340, 1500, 1800 and 1870 g/cm. It was thus observed once again that, with increasing displacement speed and thus decreasing treatment time, the peel strength is reduced. However, the value of 1340 g/cm, obtained at a displacement speed of 10 mm/s, is sufficient for practical use.

Example 3

A plate-like contact member 3, about 1 mm thick, formed by bundling fibres each 100 mm long and 20 µm in diameter, was employed. A member made of polypropylene, which has a pair of flat portions B and an intermediate raised portion A, as shown in Fig. 3, was treated in the plasma state by the surface treating apparatus K in a manner similar to that of Example 1. With respect to Fig. 3, the dimensions D, H and W were 190 mm, 20 mm and 50 mm, respectively; the dimensions M, N and L were respectively 70 mm, 70 mm and 70 mm or more.

The surface-treated plate member was subjected to spray-coating as in Example 1. The bonding of the portions A and B was examined by the 180° peel test, and the results are given in Table 1. It is apparent that there is substantially no difference in peeling strength between the portions A and B, i.e. the plate member is treated uniformly.

Table 1

| Displacement (mm/sec.) | Peel strength (g/cm) | |
|---|---|---|
| | A | B |
| 10 | 1750 | 1800 |
| 5 | 1890 | 1900 |
| 2.5 | 1950 | 1950 |
| 1.25 | 2000 | 2040 |

Example 4

A cloth-like contact member 3, formed from a stainless steel cloth 0.5 mm thick, 70 mm long and 90 mm wide was suspended from the excitation electrode 1. An aluminium plate 5 mm thick was employed as the opposite electrode 2, and to this was secured a sheet of polypropylene, 60 mm wide. The electrode 2 and the sheet 6 were displaced relative to the excitation electrode at 23 mm/s such that the contact member 3 came into wiping contact with the surface of the sheet. At the same time, a voltage of 30 kV at a frequency of 5 kHz was applied between the electrodes, to effect electrical discharge such that plasma was produced.

After it had been treated in the plasma state up to 20 times by the surface treating apparatus K, the polypropylene sheet was subjected to spray-coating using a two-part liquid system polyurethane. Immediately after drying of the spray-coating and after immersion of the sheet in hot water (40 C) for 10 days. Its bonding strength was examined by the 180° peel test. The results are given in Table 2.

### Table 2

| No. of treatments | Peel strength (Just after drying) (g/cm) | Peel strength (After immersion in water) (g/cm) |
|---|---|---|
| 0 (untreated) | <200 | <200 |
| 4 | 450 | >200 |
| 12 | 485 | >200 |
| 20 | 1140 | 650 |

Comparative Example

As in known surface treating apparatus, an aluminium plate is employed in place of the excitation electrode having the contact member 3 hung therefrom. A plate as in Example 3 was treated in the plasma state by the known surface treating apparatus in a manner similar to that of Example 3, except that there was a distance between the excitation electrode and the portion A, maintained at 3 mm. The electrode 2, having the plate member secured thereto, was displaced relative to the excitation electrode at 1.25 mm/s.

The bonding strength of the surface-treated plate was examined by the 180° peel test. The projecting portion A had a peel strength of 1370 g/cm, i.e. similar to the values obtained in Examples 1, 2 and 3, but the portions B had a peel strength no more than 200 g/cm.

CLAIMS

1.    Apparatus (K) suitable for use in the surface treatment of an article (6), in which the apparatus (K) comprises two opposing electrodes (1,2) and means for applying a high-voltage difference and thereby activating the surface of an article (6) disposed between the electrodes (1,2), characterised in that one of the electrodes (1) includes a flexible contact member (3) which can follow the contours of the article (6).

2.    Apparatus according to claim 1, in which the contact member is in the form of a brush, sheet or cloth.

3.    Apparatus according to claim 1 or claim 2, in which the contact member is formed from stainless steel, aluminium, brass or carbon.

4.    Apparatus according to any preceding claim, in which the electrode which does not include the flexible contact member carries a dielectric layer on its surface.

5.    Apparatus according to any preceding claim, in which the electrode not including the flexible contact member is made of stainless steel, aluminium, brass, iron or copper.

6.    Apparatus according to any preceding claim, which additionally comprises means for moving the contact member relative to an article to be treated.

7.    Apparatus according to any preceding claim, in which the means for applying a high-voltage difference comprises an electrical circuit adapted to provide a current sufficient to effect an electrical discharge.

8.    A method for activating the surface of an article (6), which comprises disposing the article (6) between two opposing electrodes (1,2) and applying a high-voltage difference between the electrodes (1,2), characterised in that one of the electrodes (1) includes a contact member (3) which is in contact with the article (6) and which is flexible to the extent that it can follow the contours of the article (6).

9. A method according to claim 8, in which the article is treated in oxygen or nitrogen or a mixture thereof.

10. A method according to claim 8 or claim 9, in which the article is treated at a voltage of 10 to 50 kV and a frequency of 1 to 100 kHz.

11. A method according to any of claims 8 to 10, in which the article is a plastics of fibrous product or a moulded product of paper or wood.

12. A method according to any of claims 8 to 11, in which the article is moved relative to the contact member.

13. A method according to any of claims 8 to 12, which comprises using apparatus according to any of claims 1 to 7.

*Fig. 1*

K

1

3

5

5b

4

2

5a

*Fig. 2*

1

K

3

6

4

2

*Fig. 3*

B    A    B

t

H

M    W    N

D

L

6

Fig. 4a

1

3

Fig. 4b

1

3

Fig. 4c (1)

M

1

3

Fig. 4c (2)

3

Fig. 4d (1)

3

M

1

Fig. 4d (2)

1

3

0171239

**European Patent Office**

**EUROPEAN SEARCH REPORT**

Application number

EP 85 30 5345

## DOCUMENTS CONSIDERED TO BE RELEVANT

| Category | Citation of document with indication, where appropriate, of relevant passages | Relevant to claim | CLASSIFICATION OF THE APPLICATION (Int Cl 4) |
|---|---|---|---|
| X | EP-A-0 055 686 (HIRSCHINGER)<br><br>* Page 5, lines 24-28; page 6, line 28 - page 7, line 33; figure 1; page 9, lines 8-11; figure 7; page 10, lines 19-20 * | 1,2,4,<br>6-8,11<br>-13 | H 01 T 19/00 |
| A | | 3,5,10 | |
| X | US-A-3 183 352 (BRANDT)<br><br>* Column 2, line 12 - column 3, line 16; figures 1,2 * | 1,2,6-<br>8,11-<br>13 | |
| A | | 3,10 | TECHNICAL FIELDS SEARCHED (Int. Cl.4) |
| A | US-A-4 275 301 (RUEGGEBERG)<br>* Column 2, lines 30-32; figure 1; column 3, lines 23-29 * | 9 | H 01 T |

The present search report has been drawn up for all claims

| Place of search | Date of completion of the search | Examiner |
|---|---|---|
| THE HAGUE | 17-10-1985 | BIJN E.A. |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO Form 1503 03 82